(19) **Europäisches Patentamt / European Patent Office / Office européen des brevets**

(11) **EP 4 020 821 B1**

(12) **FASCICULE DE BREVET EUROPEEN**

(45) Date de publication et mention de la délivrance du brevet:
**01.05.2024 Bulletin 2024/18**

(21) Numéro de dépôt: **21216673.0**

(22) Date de dépôt: **21.12.2021**

(51) Classification Internationale des Brevets (IPC):
*H04B 1/04* (2006.01)    *H04B 1/74* (2006.01)
*H03F 1/52* (2006.01)    *H03F 1/02* (2006.01)
*H03F 3/217* (2006.01)    *H03F 3/24* (2006.01)
*H03G 3/30* (2006.01)

(52) Classification Coopérative des Brevets (CPC):
**H04B 1/0458; H03F 1/0272; H03F 1/523;**
**H03F 3/2171; H03F 3/245; H03F 3/68; H03F 3/72;**
**H03G 3/3042;** H03F 2200/207; H03F 2200/451;
H04B 1/0483; H04B 2001/0416

(54) **SYSTÈME D'ADAPTATION DE LA TENSION D'UN DRAIN D'UN ÉTAGE DE PUISSANCE**

SYSTEM ZUR ANPASSUNG DER SPANNUNG EINES DRAINS EINER LEISTUNGSSTUFE

SYSTEM FOR ADAPTING THE VOLTAGE OF A DRAIN OF A POWER STAGE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2020 FR 2013971**

(43) Date de publication de la demande:
**29.06.2022 Bulletin 2022/26**

(73) Titulaire: **THALES**
**92190 Meudon (FR)**

(72) Inventeurs:
• **DEMENITROUX, Wilfried**
**49309 CHOLET (FR)**

• **BERTHOU, Nicolas**
**92622 GENNEVILLIERS CEDEX (FR)**
• **JARDEL, Olivier**
**31037 TOULOUSE (FR)**

(74) Mandataire: **Atout PI Laplace**
**Immeuble "Visium"**
**22, avenue Aristide Briand**
**94117 Arcueil Cedex (FR)**

(56) Documents cités:
**EP-A1- 2 709 275**    **US-A- 4 547 746**
**US-A1- 2018 342 991**

**Description**

L'invention concerne un système pour adapter la tension d'un drain d'un étage de puissance. Elle s'applique notamment pour gérer la tension de polarisation des amplificateurs de puissance positionnés, par exemple, dans un dispositif d'antenne active, afin d'éviter leur détérioration. Des exemples d'amplificateurs de puissance ont été décrits dans EP2709275 A1, US 4 547 746 A, et US2018/342991 A1

Elle trouve son application pour tous types de moyens de communication utilisant des antennes actives, par exemple, les faisceaux hertziens, les réseaux cellulaires de différentes générations (5G) et plus généralement tout moyen de communication haute fréquence F où F est supérieure à quelques centaines de Mégahertz.

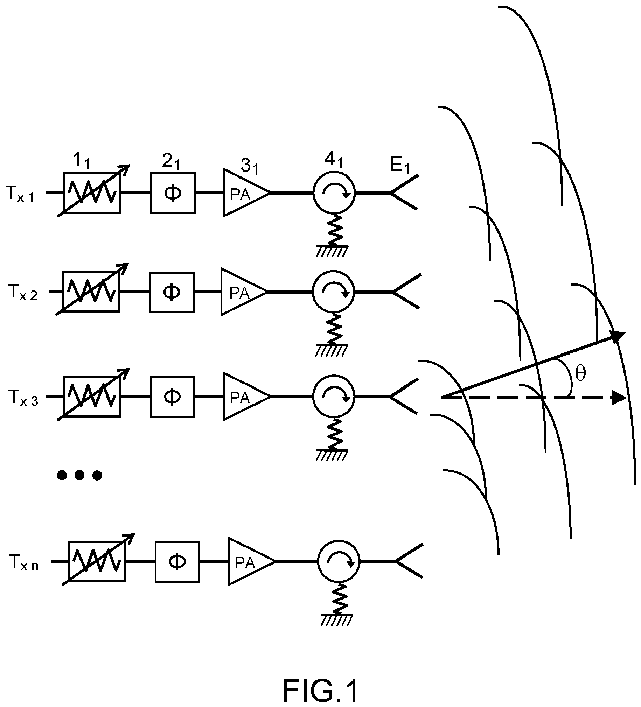

Le principe des antennes actives illustré à la figure 1 est basé sur un réseau d'antennes comprenant N voies d'émission $T_{Xi}$ avec i=1,.., N. Une voie d'émission $Tx_1$ comprend un élément résistant $1_1$, un module de contrôle de la phase $2_1$, un transistor de puissance $3_1$ en sortie duquel est disposé un élément rayonnant $E_1$ ou élément actif de l'antenne. Chaque élément actif $E_1$ est commandé en phase et en amplitude afin de former les faisceaux. Les éléments actifs (éléments rayonnants) sont positionnés très proches les uns des autres. L'impédance mutuelle rapportée à l'ensemble des éléments rayonnants peut entraîner une désadaptation d'une partie d'entre eux pouvant conduire à leur vieillissement prématuré, voire à la destruction de leur amplificateur de puissance.

Une autre solution consiste à mettre des isolateurs $4_1$ (figure 1) en sortie de transistor de puissance 3, pour protéger les chaînes de puissance. Les isolateurs (basés sur des composants à ferrite ferrites) sont encombrants, volumineux, chers, et ont des pertes d'insertion non négligeables. Ils sont donc peu adaptés pour des antennes actives, en particulier lorsque ces dernières ont un grand nombre d'éléments rayonnants et sont disposées dans des volumes restreints.

Les solutions offertes par l'art antérieur offrent différents inconvénients, le surdimensionnement des transistors utilisés qui implique un rendement dégradé, la nécessité d'ajouter des éléments isolateurs ce qui génère une augmentation de la masse, un encombrement et un coût plus élevé du système antennaire.

De plus, le vieillissement prématuré des transistors de puissance peut nécessiter leur remplacement préventif, lorsque cette option est possible.

L'invention offre notamment une solution pour résoudre au moins un ou plusieurs des problèmes de l'art antérieur. Elle propose une structure qui permet de réagir très vite dans l'adaptation de la tension de drain d'un étage de puissance afin de protéger l'étage de puissance soumis à une désadaptation importante.

L'invention concerne un système pour adapter la tension d'un drain d'un étage de puissance comme revendiqué dans la revendication 1. Des caractéristiques complémentaires du système sont définies dans les revendications dépendantes.

D'autres caractéristiques, détails et avantages de l'invention ressortiront à la lecture de la description faite en référence aux dessins annexés donnés à titre d'exemple illustratifs et non limitatifs et qui représentent, respectivement :

[Fig.1] La figure 1 est un exemple d'architecture selon l'art antérieur,

[Fig.2] La figure 2 est un schéma d'un exemple d'architecture selon l'invention,

[Fig.3] La figure 3 est un exemple de cellule de commutation.

L'exemple qui suit est donné à titre illustratif et non limitatif pour une antenne active comprenant plusieurs éléments rayonnants. L'idée est d'intégrer directement au niveau de l'étage de puissance une cellule de commutation, par exemple un convertisseur continu/continu ou DC/DC rapide qui est capable d'adapter la polarisation de puissance (tension de drain dans le cas d'un amplificateur basé sur des transistors à effet de champ) en fonction du rapport entre la puissance réfléchie $P_r$ et la puissance incidente $P_i$ en sortie des amplificateurs de chaque élément rayonnant.

Le coefficient de réflexion RC est égal au rapport $\dfrac{Vr}{Vi}$ . Les pertes de retour RL sont égales à -20$log|RC|$ et le rapport d'ondes stationnaires VSWR est défini par

$$VSWR = \frac{1+10^{-\left(\frac{RL}{20}\right)}}{1-10^{-\left(\frac{RL}{20}\right)}}.$$

On pourra tenir compte du rapport $R = \dfrac{Pr}{Pi}$ , donc du rapport des tensions $\dfrac{Vr}{Vi}$ récupéré après le coupleur, comme il sera décrit ci-après.

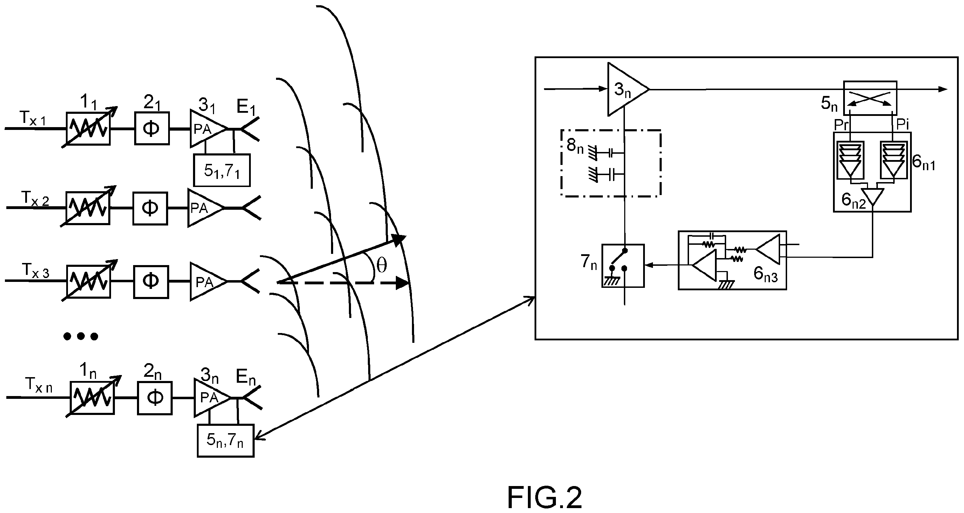

La figure 2 est un schéma d'un exemple du système configuré pour adapter la tension d'un drain d'un étage de puissance, selon un exemple de réalisation de l'invention.

Les éléments de la figure 2 communs à ceux de la figure 1 portent les mêmes références. L'indice n est utilisé pour désigner n'importe quelle chaîne d'émission.

Le système comprend un ensemble de N éléments antennaires rayonnants (éléments actifs) $E_1, ...E_n$.

Une chaîne d'émission $T_{xn}$ est composée d'une résistance d'adaptation $1_n$ positionnée devant un dispositif $2_n$ de réglage de la phase ;

En sortie du transistor de puissance $3_n$ et avant l'entrée de l'élément actif $E_n$, la chaîne d'émission comprend un coupleur $5_n$. Le coupleur $5_n$ a notamment pour fonction de prélever les tensions $V_i$ et $V_r$ qui sont une image respectivement des puissances incidentes et réfléchies. Un dispositif analogique $6_n$ basé sur des amplificateurs logarithmiques $6_{n1}$ et un soustracteur $6_{n2}$ permet de générer en sa sortie une tension « $V_{ra}$ », image du rapport des puissances puissance incidente $P_i$ et réfléchie $P_r$. Ce dispositif analogique étant connu de l'homme du métier, il ne fera pas l'objet d'une description détaillée.

Un dispositif de modulation analogique $6_{n3}$ est configuré pour moduler cette tension $V_{ra}$ en largeur d'impulsions MLI connu aussi sous l'abréviation anglaise PWM ou Puise Width Modulation.

Le signal MLI généré est transmis à une cellule de polarisation variable basée sur la cellule de commutation rapide. Il commande cette cellule de polarisation et permet de moduler la tension de drain $V_{ds}$ de l'amplificateur de puissance.

La cellule de commutation reçoit un signal carré faible puissance (type MLI) et renvoie un signal carré (MLI) de puissance. Un filtre passe-bas à sa sortie (typiquement des capacités de taille importante) permet de transformer ce signal carré en un signal DC, qui est le signal de polarisation et qui est variable en fonction des largeurs des impulsions.

La valeur de tension de polarisation du drain sera déterminée à partir d'une loi préétablie L= f(R) qui définit la valeur de la polarisation du transistor de puissance en fonction du signal MLI.

La cellule de commutation $7_n$ reçoit le signal MLI et retourne le même signal $MLI_a$, mais amplifié par découpage. Par passage de ce signal « de puissance » dans un filtre passe bas $8_n$, on obtient une tension de polarisation $V_{pv}$ de puissance variable. Le filtre passe-bas peut être réalisé par un réseau de capacités habituellement placé sur l'accès de polarisation de l'amplificateur.

La mesure des valeurs de puissances et le calcul du rapport de la puissance incidente et de la puissance réfléchie permet de changer la valeur de polarisation jusqu'à une valeur minimale déterminée à l'avance pour protéger chaque amplificateur qui sera surchargé par le rapport d'ondes stationnaires de tension des autres.

Tout paramètre similaire au rapport des puissances pourra aussi être utilisé pour mettre en oeuvre l'invention.

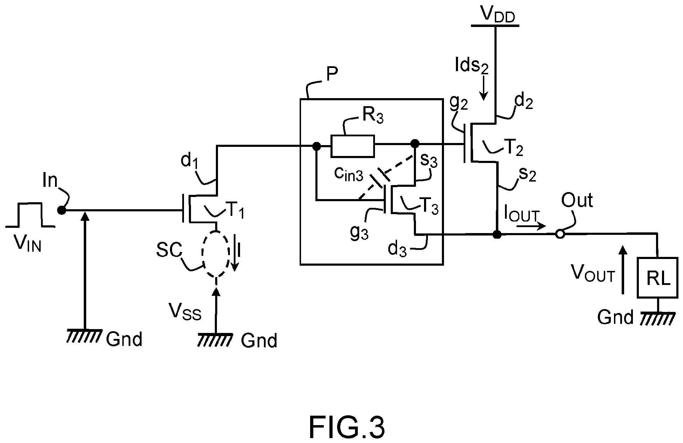

La figure 3 illustre l'utilisation d'une cellule de commutation telle que décrite dans le brevet EP 3134972 du demandeur. Cette cellule est constituée de trois transistors normalement conducteurs (par exemple HEMTs GaN RF) agencés de manière à amplifier en tension un signal d'entrée (en l'occurrence le signal MLI), avec une bande passante très élevée (le signal d'entrée peut avoir une fréquence de plusieurs dizaines de MHz), rendant ainsi le système très rapide.

Le commutateur de courant formé par le transistor d'entrée $T_1$ et le transistor de puissance $T_2$ commute la haute tension $V_{dd}$.

Le circuit d'auto-polarisation de grille P comprend :

- un transistor $T_3$ qui est un transistor à effet de champ de type normalement conducteur, connecté comme suit : son drain $d_3$ est relié à la source $s_2$ du transistor de puissance $T_2$ et donc au plot de sortie Out de la cellule ; sa source $s_3$ est reliée à la grille $g_2$ ; sa grille $g_3$ est reliée à la résistance $R_3$, et

- une résistance d'auto-polarisation $R_3$ de la grille $g_3$ du transistor $T_3$, connectée entre cette grille $g_3$ et la source $s_3$ du transistor $T_3$, et en série avec le drain du premier transistor $T_1$.

La résistance $R_1$ sur le drain du transistor $T_1$, présente dans la cellule antérieure, n'est pas représentée ici. Elle est optionnelle.

L'ensemble formé par le circuit d'auto-polarisation P et le transistor de puissance $T_2$ constitue la charge du transistor d'entrée $T_1$, charge qui est ainsi placée en série entre le drain $d_1$ du transistor $T_1$ et la tension d'alimentation positive $V_{dd}$.

Dans cette structure, le transistor $T_3$ est, comme le transistor $T_2$, un transistor à source flottante, au sens que sa source $s_3$ n'est pas référencée à un potentiel fixe : elle suit la tension de grille du transistor de puissance $T_2$.

Dans l'exemple, le commutateur de courant est formé d'un transistor $T_1$, il pourrait, sans sortir du cadre l'invention, en comprendre plusieurs, par exemple pour former une paire différentielle.

Le fonctionnement d'une cellule selon l'invention va maintenant être expliqué, en considérant une charge purement résistive de sortie, notée RI.

La cellule a deux états stables, les états ON et OFF :

- la cellule est dite à l'état ON lorsque les transistors $T_2$ et $T_3$ sont passants (état ON), et que la structure délivre de la puissance à la charge,

- la cellule est dite à l'état OFF lorsque les transistors $T_2$ et $T_3$ sont à la limite du blocage (état OFF) et que la charge est isolée de l'alimentation principale,

Les transistors $T_3$ et $T_2$ sont commandés à l'état On, passant ou OFF, bloqué, en fonction du signal de commande $V_{IN}$ appliqué en entrée In de la cellule, et qui commande l'état ON ou OFF du transistor $T_1$.

L'invention trouve son application dans le domaine des antennes actives fonctionnant dans des bandes de fréquence au-dessus de 800 MHz, Satcom, réseaux 4G/5G, etc.

Le système selon l'invention présente notamment les avantages suivants :

La possibilité de couper l'alimentation de la chaîne d'amplification afin de la protéger de façon très rapide (quelques ns) car la cellule de commutation utilisée est elle-même très rapide,

Le fait de pouvoir réaliser des modules d'amplification sans isolateurs dans une antenne active,

Un dimensionnement adapté dans la section d'amplification, sans la nécessité de « surdimensionner » les transistors de puissance.

## Revendications

1. Système pour adapter une tension d'un drain d'un étage de puissance, le système comprenant au moins deux voies d'émission $T_{Xn}$, une voie d'émission comprenant un élément résistant $(1_n)$, un module de contrôle de phase $(2_n)$, et l'étage de puissance $(3_n)$ en sortie duquel est disposé au moins un élément rayonnant $(E_n)$, le système comprenant au moins :

    - Un dispositif $(5_n)$ configuré pour déterminer une valeur de puissance réfléchie $P_r$, une valeur de puissance incidente $P_i$ au niveau de l'étage de puissance,
    - Un dispositif analogique $(6_n)$ configuré pour générer une tension image d'un rapport de la puissance incidente Pi et de la puissance réfléchie Pr et moduler ladite tension image dudit rapport de puissances en largeur d'impulsion, ce qui fournit un signal de faible puissance MLI,
    - Une cellule de commutation $(7_n)$ configurée pour recevoir ledit signal de faible puissance MLI et pour générer un signal de puissance $MLI_a$ par amplification du signal de faible puissance,
    - Un filtre passe-bas $(8_1)$ configuré pour transformer ledit signal de puissance $MLI_a$ en un signal de polarisation de l'étage de puissance selon une loi de commande de polarisation prédéfinie.

2. Système selon la revendication 1 **caractérisé en ce que** l'étage de puissance est un transistor de puissance et **en ce que** le système comporte un élément antennaire rayonnant situé en sortie du transistor de puissance, ledit élément rayonnant étant l'élément antennaire rayonnant.

3. Système selon l'une des revendications 1 ou 2 **caractérisé en ce que** :

    - le dispositif $(5_n)$ est un coupleur configuré pour prélever des tensions $V_i$ et $V_r$ images respectivement de la puissance incidente $P_i$ et de la puissance réfléchie $P_r$.
    - le dispositif analogique $(6_n)$ comprend plusieurs amplificateurs logarithmiques $(6_{n1})$, un soustracteur $(6_{n2})$ adapté pour générer en sortie ladite tension image du rapport de puissances, et un dispositif de modulation analogique $(6_{n3})$ configuré pour moduler ladite tension image du rapport de puissance en largeur d'impulsions.

4. Système selon l'une des revendications 1 à 3, **caractérisé en ce que** ledit au moins un élément rayonnant est configuré pour fonctionner dans des bandes de fréquence supérieures à 800 MHz.

5. Système selon l'une des revendications 1 à 3, **caractérisé en ce que** ledit au moins un élément rayonnant est configuré pour fonctionner dans des réseaux 4G/5G.

## Patentansprüche

1. System zum Anpassen einer Spannung eines Drains einer Leistungsstufe, wobei das System mindestens zwei Sendekanäle $T_{Xn}$ umfasst, wobei ein Sendekanal ein Widerstandselement $(1_n)$, ein Phasensteuermodul $(2_n)$ und die Leistungsstufe $(3_n)$ umfasst, an deren Ausgang mindestens ein Strahlungselement $(E_n)$ angeordnet ist, wobei das System mindestens Folgendes umfasst:

    - eine Vorrichtung $(5_n)$, konfiguriert zum Bestimmen eines Wertes von reflektierter Leistung $P_r$, eines Wertes von einfallender Leistung $P_i$ an der Leistungsstufe,
    - eine analoge Vorrichtung $(6_n)$, konfiguriert zum Erzeugen einer Spannung als Abbild eines Verhältnisses der einfallenden Leistung Pi und der reflektierten Leistung Pr und zum Pulsweitenmodulieren der Spannung als Abbild des Leistungsverhältnisses, wodurch ein PWM-Niedrigleistungssignal bereitgestellt wird,
    - eine Schaltzelle $(7_n)$, konfiguriert zum Empfangen des PWM-Niedrigleistungssignals und zum Erzeugen eines $PWM_a$-Leistungssignals durch Verstärken des Niedrigleistungssignals,
    - ein Tiefpassfilter $(8_1)$, konfiguriert zum Transformieren des $PWM_a$-Leistungssignals in ein Vorspannungssignal zum Vorspannen der Leistungsstufe gemäß einem vordefinierten Vorspannungssteuerungsgesetz.

2. System nach Anspruch 1, **dadurch gekennzeichnet, dass** die Leistungsstufe ein Leistungstransistor ist, und dadurch, dass das System ein Antennenstrahlungselement umfasst, das sich am Ausgang des Leistungstransistors befindet, wobei das Strahlungselement das Antennenstrahlungselement ist.

3. System nach Anspruch 1 oder 2, **dadurch gekenn-**

**zeichnet, dass**:

- die Vorrichtung ($5_n$) ein Koppler ist, konfiguriert zum Erfassen der Spannungen V; und $V_r$ als Abbild jeweils der einfallenden Leistung $P_i$ und der reflektierten Leistung $P_r$;
- die analoge Vorrichtung ($6_n$) mehrere logarithmische Verstärker ($6_{n1}$), einen Subtrahierer ($6_{n2}$), ausgelegt zum Erzeugen der Spannung als Abbild des Leistungsverhältnisses am Ausgang, und eine analoge Modulationsvorrichtung ($6_{n3}$) umfasst, die zum Pulsweitenmodulieren der Spannung als Abbild des Leistungsverhältnisses konfiguriert ist.

**4.** System nach einem der Ansprüche 1 bis 3, **dadurch gekennzeichnet, dass** das mindestens eine Strahlungselement zum Arbeiten in Frequenzbändern oberhalb von 800 MHz konfiguriert ist.

**5.** System nach einem der Ansprüche 1 bis 3, **dadurch gekennzeichnet, dass** das mindestens eine Strahlungselement zum Arbeiten in 4G/5G-Netzen konfiguriert ist.

**Claims**

**1.** A system for adapting a drain voltage of a power stage, the system comprising at least two transmission paths $T_{Xn}$, a transmission path comprising a resistive element ($1_n$), a phase control module ($2_n$), and the power stage ($3_n$) at the output of which at least one radiating element ($E_n$) is arranged, the system comprising at least:

- a device ($5_n$) configured to determine a value of a reflected power $P_r$, a value of an incident power $P_i$ in at the power stage,
- an analogue device ($6_n$) configured to generate a voltage that is an image of a ratio of the incident power Pi and the reflected power Pr and to pulse width-modulate said voltage that is an image of said power ratio, thereby providing a low-power PWM signal,
- a switching cell ($7_n$) configured to receive said low-power PWM signal and to generate a power signal $PWM_a$ by amplifying the low-power signal,
- a low-pass filter ($8_1$) configured to transform said power signal $PWM_a$ into a bias signal for biasing the power stage in accordance with a predefined bias control law.

**2.** The system according to claim 1, **characterised in that** the power stage is a power transistor and **in that** the system has a radiating antenna element located at the output of the power transistor, said radiating element being the radiating antenna element.

**3.** The system according to one of claims 1 or 2, **characterised in that**:

- the device ($5_n$) is a coupler configured to tap off voltages $V_i$ and $V_r$ that are respectively images of the incident power $P_i$ and of the reflected power $P_r$,
- the analogue device ($6_n$) comprises multiple logarithmic amplifiers ($6_{n1}$), a subtractor ($6_{n2}$) designed to generate, at output, said voltage that is an image of the power ratio, and an analogue modulation device ($6_{n3}$) configured to pulse width-modulate said voltage that is an image of the power ratio.

**4.** The system according to one of claims 1 to 3, **characterised in that** said at least one radiating element is configured to operate in frequency bands greater than 800 MHz.

**5.** The system according to one of claims 1 to 3, **characterised in that** said at least one radiating element is configured to operate in 4G/5G networks.

FIG.1

FIG.2

FIG.3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2709275 A1
- US 4547746 A
- US 2018342991 A1
- EP 3134972 A